# EUROPÄISCHE PATENTSCHRIFT

(11) **EP 1 005 642 B1**
(45) Veröffentlichungstag und Bekanntmachung des Hinweises auf die Patenterteilung: **13.10.2004**
(21) Anmeldenummer: 98949874.6
(22) Anmeldetag: 11.08.1998
(51) Int. Cl.: G01N 27/04

(54) **VERFAHREN UND VORRICHTUNG ZUR ERMITTLUNG EINER KENNGRÖSSE FÜR EIN METALLISIERUNGSBAD**
METHOD AND DEVICE FOR DETERMINING A PARAMETER FOR A METALLIZATION BATH
PROCEDE ET DISPOSITIF POUR DETERMINER UN PARAMETRE RELATIF A UN BAIN DE METALLISATION

(30) Priorität: 21.08.1997 DE 19736113
(43) Veröffentlichungstag der Anmeldung: 07.06.2000
(73) Patentinhaber: Pac Tech - Packaging Technologies GmbH, 14641 Nauen (DE)
(72) Erfinder: MOTULLA, Gerald, D-13357 Berlin (DE)
(74) Vertreter: Tappe, Hartmut
(86) Internationale Anmeldenummer: PCT/DE1998/002301
(87) Internationale Veröffentlichungsnummer: WO 1999/010734

(56) Entgegenhaltungen:
- EP-A- 0 113 395
- FR-A- 2 656 696
- US-A- 4 882 537
- V. MARKOVICH: "TAKE TIME MONITOR" IBM TECHNICAL DISCLOSURE BULLETIN, Bd. 26, Nr. 10B, 1984, Seite 5730 XP002091060
- G. MOTULLA: "A LOW COST BUMPING PROCESS FOR FLIP CHIP-TECHNOLOGY USING ELECTROLESS NICKEL BUMPING AND SOLDER BALL PLACEMENT" 1ST 1997 IEMT/IMC SYMPOSIUM,April 1997, Seiten 174-181, XP002091061 TOKYO, JP

## Beschreibung

Die vorliegende Erfindung betrifft ein Verfahren zur Ermittlung der Konzentration eines einem Metallisierungsbad hinzugefügten Badstabilisators und/oder einer Abscheidegeschwindigkeit eines Metallisierungsmaterials im Metallisierungsbad bei Ausbildung der Kontaktmetallisierung für die reproduzierbare Herstellung erhöhter Kontaktmetallisierungen auf Anschlußflächen eines Substrats mittels Abscheidung eines Metallisierungsmaterials in einem Metallisierungsbad gemäß dem Oberbegriff der Ansprüche 1 oder 3, eine zur Durchführung des Verfahrens geeignete Vorrichtung gemäß Anspruch 8.

Bei der Herstellung erhöhter Kontaktmetallisierungen, die fachsprachlich auch als "Bumps" bezeichnet werden, auf Anschlußflächen eines Substrats, wie beispielsweise eines Chips oder eines Trägersubstrats, das zur Plazierung von Chips oder anderen elektronischen Bauelementen dient, haben sich in der Praxis Maßnahmen als notwendig erwiesen, die eine Reproduzierbarkeit des Herstellungsverfahrens ermöglichen, um Bumps mit einheitlicher Morphologie herstellen zu können. Dies gilt unabhängig von dem für die Bump-Herstellung gewählten Verfahren, insbesondere für Verfahren, bei denen die Bumps durch eine Metallabscheidung in einem Metallisierungsbad hergestellt werden. Dies kann auf elektrolytischem oder naßchemischem Weg geschehen.

Aus der EP 0 113 395 A2 ist ein Verfahren zur Feststellung bzw. zur Überwachung des Beginns bzw. des Fortschritts der Abscheidung eines Kontaktmetalls auf Durchkontaktierungen in einem Testsubstrat bekannt. Dabei findet eine Abscheidung eines Metallisierungsmaterials zwischen zwei Kontaktmetallisierungen statt. Als Kenngröße für den Beginn und Fortschritt der Metallabscheidung dient der elektrische Widerstand, der in Zusammenhang mit der Materialmenge des auf den Wandungen der Durchkontaktierungen abgeschiedenen Metalls gesetzt wird.

Im IBM Technical Bulletin, Bd.26, Nr.10B, 1984, Seite 5730 wird ein Verfahren beschrieben, das die Messung der Aktivität von Metallisierungsbädern ermöglicht. Hierzu wird ein Testsubstrat verwendet, das mit zwei Kontaktflächen versehen ist, auf denen eine metallische Abscheidung stattfindet. Als Maß für die Badaktivität wird die Zeit angesehen, die für die Ausbildung einer leitenden Verbindung zwischen den Kontaktflächen durch Ausbildung einer metallischen Abscheidung auf den Kontaktflächen benötigt wird.

Der vorliegenden Erfindung liegt die Aufgabe zugrunde, ein Verfahren zur Ermittlung einer Kenngröße vorzuschlagen, die eine einfache Kontrolle der Vorgänge in einem Metallisierungsbad ermöglicht, um hinsichtlich ihrer Morphologie reproduzierbare Bumps herstellen zu können.

Eine erste Lösung der der Erfindung zugrundeliegenden Aufgabe weist die Merkmale des Anspruchs 1 auf.

Gemäß dieser ersten Lösung wird ein Verfahren vorgeschlagen, bei dem erfindungsgemäß ein Testsubstrat mit mindestens zwei in definiertem Abstand benachbarten Anschlußflächen in das Metallisierungsbad eingebracht wird und die Konzentration eines einem Metallisierungsbad hinzugefügten Badstabilisators und/oder einer Abscheidegeschwindigkeit eines Metallisierungsmaterials einer Kontaktmetallisierungen im Metallisierungsbad bei Ausbildung der Kontaktmetallisierung aus der Veränderung einer elektrischen Größe infolge eines sich aus dem Aufbau der Kontaktmetallisierungen auf den benachbarten Anschlußflächen ergebenden elektrischen Kontakts ermittelt wird.

Bei dem erfindungsgemäßen Verfahren wird durch den sich aus dem kontinuierlichen Aufbau der Kontaktmetallisierungen auf den Anschlußflächen ergebenden Körperkontakt zwischen den Kontaktmetallisierungen ein elektrisches Signal induziert, das bei definiertem, also bekanntem Abstand zwischen den Anschlußflächen einen Rückschluß auf zumindest die flächige Ausdehnung der Kontaktmetallisierung ermöglicht. Bei einem isotropen Abscheidevorgang des im Metallisierungsbad gelösten Metallisierungsmaterials auf den Anschlußflächen des Substrats, also bei einem gleichmäßigen "Aufwachsen" des Metallisierungsmaterials auf der Oberfläche sowie in den Rand- oder Kantenbereichen der Anschlußfläche sind darüber hinaus direkte Rückschlüsse auf die Gestalt der erhöhten Kontaktmetallisierungen möglich.

In der Praxis hat sich der Einfluß sogenannter "Stabilisierungskomponenten" auf den Abscheidevorgang bzw. die Morphologie der in einem mit derartigen Stabilisierungskomponenten versehenen Metallisierungsbad abgeschiedenen Kontaktmetalliserungen teilweise als erheblich herausgestellt. Insbesondere hat sich gezeigt, daß bereits geringe Abweichungen in der Dosierung derartiger Stabilisierungskomponenten in einem Metallisierungsbad unverhältnismäßig große Auswirkungen auf die Morphologie der abgeschiedenen Kontaktmetallisierungen haben. Dies liegt im wesentlichen darin begründet, daß die Stabilisierungskomponenten, die die Zersetzung der Metallisierungsbäder bzw. eine unerwünschte Abscheidung des Metallisierungsmaterials auf den Wandungen der Badbehälter verhindern sollen, ein Diffusionsverhalten aufweisen, das der gewünschten Abscheidung auf den Anschlußflächen entgegenwirkt. Darüber hinaus erweist sich das Verhalten vieler Stabilisierungskomponenten, wie beispielsweise Blei, hinsichtlich der Diffusion in die Oberfläche der in der Regel als Aluminium-Pads ausgeführten Anschlußflächen als nicht-linear, so daß in den Randbereichen der Anschlußflächen eine größere abscheidungshemmende Wirkung feststellbar ist, als im Bereich der Oberfläche der Anschlußflächen. Daher ergeben sich aus der Verwendung von Stabilisierungskomponenten in einem Metallisierungsbad erhebliche Auswirkungen auf die Morphologie der auf den Anschlußflächen abgeschiedenen Kontaktmetallisierungen. So hat es sich als notwendig erwiesen, die Konzentration der Stabilisierungskomponenten im Metallisierungsbad ständig zu überwachen, um hinsichtlich ihrer Morphologie gleichbleibende Kontaktmetallisierungen herstellen zu können.

Als besonders vorteilhaft hat es sich erwiesen, wenn die Konzentration eines einem Metallisierungsbad hinzugefügten Badstabilisators und/oder einer Abscheidegeschwindigkeit eines Metallisierungsmaterials einer Kontaktmetallisierung im Metallisierungsbad bei Ausbildung der Kontaktmetallisierung aus der Veränderung des elektrischen Widerstands eines die Anschlußflächen umfassenden elektrischen Meßkreises ermittelt wird.

Eine weitere Lösung der der Erfindung zugrundeliegenden Aufgabe weist die Merkmale des Anspruchs 3 auf.

Bei dieser Lösung wird erfindungsgemäß ein Testsubstrat mit mindestens einer Anschlußfläche in das Metallisierungsbad eingebracht und die Konzentration des Badstabilisators und/oder der Abscheidegeschwindigkeit aus der Messung einer durch die Masse der Kontaktmetallisierung auf der Anschlußfläche bedingten elektrischen Größe ermittelt. Im Unterschied zu der vorgenannten ersten Lösung wird hierbei nicht durch die Relation zweier auf in definiertem Abstand benachbarten Anschlußflächen abgeschiedener Kontaktmetallisierungen auf die Morphologie der einzelnen Kontaktmetallisierung geschlossen, sondern vielmehr durch die während des Abscheidevorgangs sich auf der Anschlußfläche ausbildende Metalliserungsmasse, die die elektrischen Eigenschaften der aus der Anschlußfläche und der Metallisierungsmasse gebildeten Einheit verändert.

Besonders vorteilhaft ist es in diesem Zusammenhang, wenn die Konzentration des Badstabilisators und/oder der Abscheidegeschwindigkeit aus dem Wert des elektrischen Widerstands eines an die Anschlußfläche angeschlossenen elektrischen Meßkreises ermittelt wird. Diese Variante des erfindungsgemäßen Verfahrens basiert darauf, daß neben der Dichte des Metallisierungsmaterials der sich auf der Anschlußfläche ausbildende Kontaktmetallisierungsquerschnitt sowie die Länge der auf der Anschlußfläche ausgebildeten Kontaktmetallisierung den Wert des Ohmschen Widerstands bestimmen. Bei bekannten elektrischen Größen der Anschlußfläche lassen sich hieraus, insbesondere bei einem isotropen Abscheidungsvorgang, direkte Rückschlüsse auf die Morphologie der Kontaktmetallisierung ziehen.

Um ausgehend von dem beiden erfindungsgemäßen Lösungen zugrunde liegenden Lösungsprinzip, nämlich der Ermittlung einer Konzentration des Badstabilisators und/oder der Abscheidegeschwindigkeit basierend auf in einem elektrischen Meßkreis ermittelten elektrischen Größen, eine im wesentlichen vom Meßstrom unbeeinflußte Ermittlung der Konzentration des Badstabilisators und/oder der Abscheidegeschwindigkeit zu ermöglichen, wird vorgeschlagen, den elektrischen Meßkreis zur Erfassung der elektrischen Größe, also beispielsweise des Widerstands, nur zeitweise, vorzugsweise periodisch, zu schließen. Hierdurch ist es beispielsweise möglich, die Überlagerung eines rein naßchemischen Abscheidevorgangs mit galvanischen Effekten, infolge eines Stromflusses zwischen den Anschlußflächen bzw. zwischen dem Metallisierungsbad und der bzw. den Anschlußflächen, weitestgehend zu unterdrücken.

Besonders vorteilhaft ist es, wenn zur Ermittlung der Konzentration des Badstabilisators ein Testsubstrat mit einer Mehrzahl von Anschlußflächenanordnungen verwendet wird, die jeweils zwei einander mit definiertem Kontaktabstand zugeordnete Anschlußflächen umfassen, wobei die Kontaktabstände bei den einzelnen Anschlußflächenanordnungen variieren. Das Testsubstrat wird über eine vorbestimmte Zeitspanne in das Metallisierungsbad eingetaucht. Während dieser Zeitspanne erfolgt eine wiederholte Messung des elektrischen Widerstands zwischen den Anschlußflächen der jeweiligen Anschlußflächenanordnungen, und die Stabilisatorkonzentration wird in Abhängigkeit vom maximalen Kontaktabstand der Anschlußflächen mit Kurzschlußkontakt durch Vergleich mit Kontaktabstand-Referenzwerten für bekannte Stabilisatorkonzentrationen ermittelt.

Gemäß einer bevorzugten Variante des Verfahrens wird zur Ermittlung der Abscheidegeschwindigkeit das Testsubstrat, das mit mindestens einer Anschlußflächenanordnung versehen ist, die jeweils zwei einander mit definiertem Kontaktabstand zugeordnete Anschlußflächen umfaßt, in das Metallisierungsbad eingetaucht. Anschließend erfolgt eine wiederholte Messung des elektrischen Widerstands zwischen den Anschlußflächen der Anschlußflächenanordnung, und die Zeit bis zur Ausbildung eines Kurzschlußkontakts zwischen den Anschlußflächen wird gemessen.

Zur Durchführung der Verfahrensvariante, bei der zur Ermittlung der Konzentration des Badstabilisators und/oder der Abscheidedauer der durch die Masse der Kontaktmetallisierung bedingte elektrische Widerstand gemessen wird, weist das Testsubstrat mindestens eine Anschlußfläche auf, wobei die Anschlußfläche einen elektrischen Leiter eines eine Widerstandsmeßeinrichtung umfassenden elektrischen Meßkreises bildet.

Ein zur Durchführung des erfindungsgemäßen Verfahrens besonders geeignete Vorrichtung weist Testsubstrat mit einer Mehrzahl an Seitzen von Anschlußflächenanordnungen mit einer Mehrzahl von Anschlußflächenanordnungen auf, wobei die Anschlußflächenanordnungen jeweils zwei in definiertem Kontaktabstand einander zugeordnete Anschlußflächen aufweisen und die Anschlußflächen Kurzschlußpole eines eine Widerstandsmeßeinrichtung umfassenden elektrischen Meßkreises bilden. Dabei sind die Kontaktabstände zwischen einander zugeordneten Anschlußflächen verschiedener Anschlußflächenanordnungen unterschiedlich.

Ein derart aufgebautes Testsubstrat ermöglicht sowohl die Bestimmung der in einem Metallisierungsbad enthaltenen Konzentration einer Stabilisierungskomponente als auch die Bestimmung der Abscheidegeschwindigkeit des Metallisierungsmaterials auf den Anschlußflächen.

Jeder Satz weist Anschlußflächen übereinstimmender Größe und die verschiedenen Sätze weisen Anschlußflächen unterschiedlicher Größe auf Daher, ist es bei Durchführung des Verfahrens zugleich möglich, durch das nicht-lineare Diffusionsverhalten der Stabilisierungskomponente in die Oberfläche der Anschlußflächen bedingte Einflüsse zu erfassen, die zu einer anisotropen Abscheidung auf den Anschlußflächen führen.

Insbesondere für den Fall einer stark anisotropen Abscheidung des Kontaktmaterials auf den Anschlußflächen eignet sich eine Ausführung des Testsubstrats mit einer räumlichen Anordnung der Anschlußflächen, derart, daß zur Ausbildung des Kontaktabstands zwischen zwei einander zugeordneten Anschlußflächen die Anschlußflächen in beabstandeten Substratebenen angeordnet sind.

Nachfolgend werden bevorzugte Varianten des Verfahrens bzw. bevorzugte Ausführungsformen der zur Durchführung des Verfahrens geeigneten Vorrichtung anhand der Zeichnungen näher erläutert. Es zeigen:
- **Fig 1**: ein in ein Metallisierungsbad eingetauchtes Testsubstrat vor Beginn der Abscheidung von Kontaktmetallisierungen;
- **Fig. 2**: das in **Fig. 1** dargestellte Testsubstrat in einem Zwischenstadium mit zum Teil ausgebildeten Kontaktmetallisierungen;
- **Fig. 3**: das in **Fig. 1** dargestellte Testsubstrat in einem Kontaktstadium der Kontaktmetallisierungen;
- **Fig. 4**: eine weitere Ausführungsform eines Testsubstrats mit mehreren Sätzen von Anschlußflächenanordnungen mit Anschlußflächen unterschiedlicher Größe;
- **Fig. 5 bis 8**: die Ausbildung von Kontaktmetallisierungen auf Anschlußflächen einer Anschlußflächenanordnung des in **Fig. 4** dargestellten Testsubstrats in unterschiedlichen Metallisierungsbädern;
- **Fig. 9**: auf unterschiedlich großen Anschlußflächen abgeschiedene Kontaktmetallisierungen;
- **Fig. 10**: eine weitere Ausführungsform eines Testsubstrats mit räumlicher Anordnung von Anschlußflächen in einer Seitenansicht;
- **Fig. 11**: das in **Fig. 10** dargestellte Testsubstrat in einer Draufsicht;
- **Fig. 12**: das in **Fig. 11** dargestellte Testsubstrat in einer Schnittdarstellung gemäß Schnittlinienverlauf XII-XII;

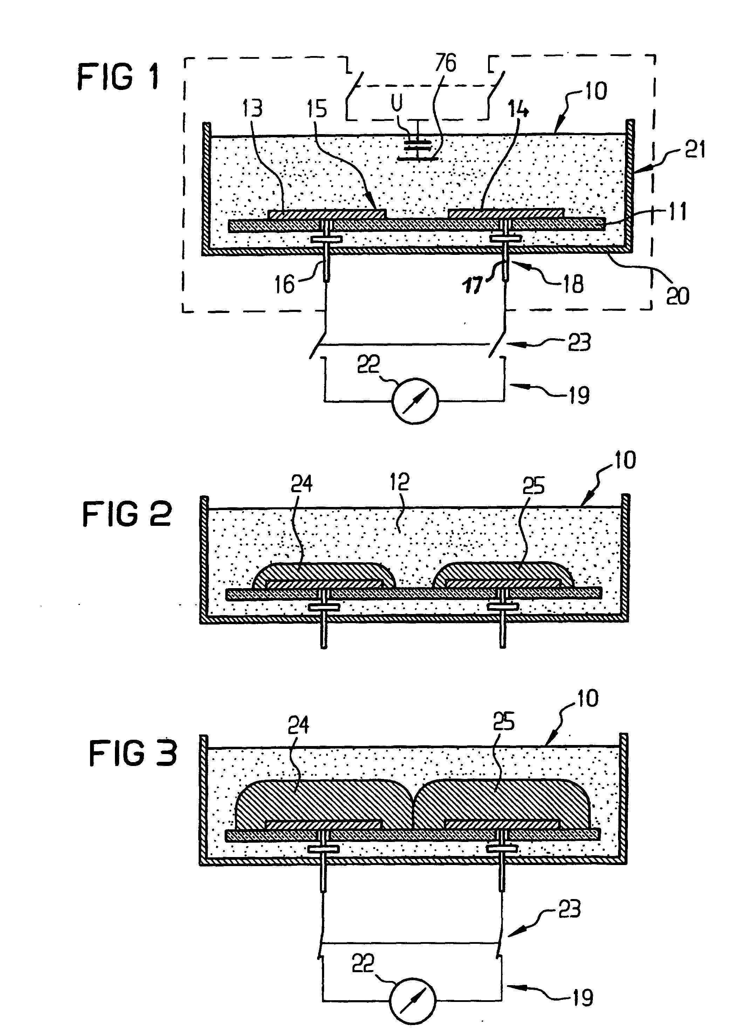

**Fig. 1** zeigt ein in ein Metallisierungsbad 10 eingesetztes Testsubstrat 11 unmittelbar nach dem Einsetzen in das Metallisierungsbad 10 vor Beginn der Abscheidung von einem im Metallisierungsbad 10 gelösten Metallisierungsmaterial 12 auf einer durch zwei Anschlußflächen 13 und 14 gebildeten Anschlußflächenanordnung 15 des Testsubstrats 11.

Bei dem in Fig 1 dargestellten und im folgenden erwähnten Metallisierungsbad kann es sich um ein Nickelbad handeln, das beispielsweise zur Ausbildung von Kontaktmetallisierungen auf Aluminium-Anschlußflächen, die fachsprachlich auch als Aluminium-Pads bezeichnet werden, dient. Das Substrat kann im wesentlichen aus Silicium gebildet sein, wie es beispielsweise bei einem Chip oder Wafer der Fall ist.

Die Anschlußflächen 13 und 14 des Testsubstrats 11 sind im vorliegenden Fall über eine Kontaktanordnung 18 mit zwei Durchkontaktierungen 16 und 17 an einen elektrischen Meßkreis 19 angeschlossen. Die Durchkontaktierungen 16, 17 durchdringen eine Behälterwand 20 eines das Metallisierungsbad 10 aufnehmenden Badbehälters 21. Die hier beispielhaft dargestellte Kontaktanordnung kann auch als Eintauch-Kontaktanordnung ausgebildet sein, ohne die Behälterwand zu durchdringen. Der Meßkreis 19, der eine Widerstandsmeßeinrichtung 22 aufweist, ist mit einer Schalteranordnung 23 versehen, die ein Öffnen und Schließen des elektrischen Meßkreises 19 ermöglicht.

**Fig. 2** gibt den Zustand der Anschlußflächen 13, 14 des Testsubstrats 11 nach fortgeschrittener Eintauchzeit wieder, wobei sich bereits deutlich sichtbar Kontaktmetallisierungen 24, 25 auf den Anschlußflächen 13, 14 durch naßchemische Abscheidung des Metallisierungsmaterials 12 aus dem Metallisierungsbad 10 bilden.

**Fig. 3** zeigt die auf den Anschlußflächen 13, 14 durch Abscheidung des Metallisierungsmaterials 12 ausgebildeten Kontaktmetallisierungen 24, 25 in einem fortgeschrittenen Stadium, in dem die Kontaktmetallisierungen 24, 25 unter Ausbildung eines Berührungskontakts zusammengewachsen sind und in diesem Kontaktzustand einen Kurzschluß des Meßkreises 19 in Schließstellung der Schalteranordnung 23 ermöglichen. Dieser Moment des Zusammenwachsens der Kontaktmetallisierungen 24, 25 ist durch einen drastischen Abfall des durch die Widerstandsmeßeinrichtung 22 gemessenen Widerstandswertes deutlich erkennbar.

Aus der vorgenannten Korrelation zwischen dem Zusammenwachsen der Kontaktmetallisierungen 24, 25 und der deutlichen Änderung einer elektrischen Kenngröße des Meßkreises 19 ergeben sich Möglichkeiten, charakteristische Kenngrößen für den im Metallisierungsbad 10 stattfindenden Abscheidungsvorgang zu ermitteln, die auf einfache Art und Weise eine Überwachung des Abscheidungsvorgangs zur reproduzierbaren Herstellung von Kontaktmetallisierungen definierter Größe oder Morphologie ermöglichen.

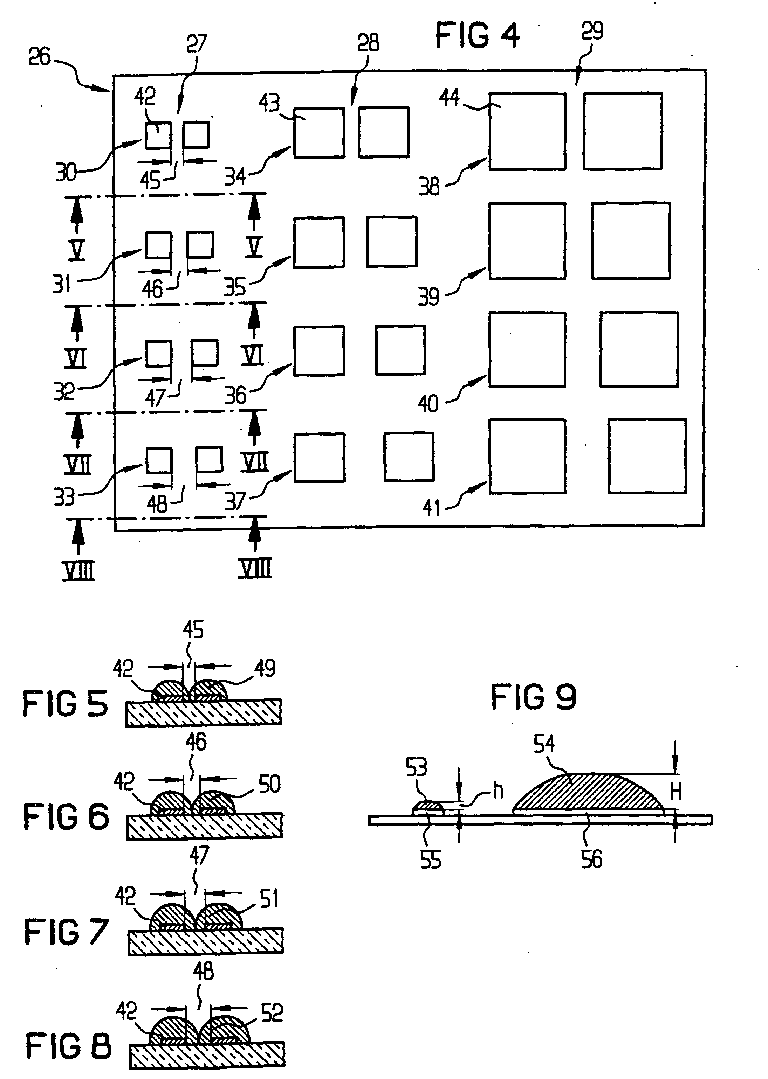

**Fig. 4** zeigt ein Testsubstrat 26 mit drei Anschlußflächenanordnungssätzen 27, 28 und 29, die jeweils vier Anschlußflächenanordnungen 30 bis 33 bzw. 34 bis 37 bzw. 38 bis 41 mit jeweils verschieden großen Anschlußflächen 42, 43 und 44 aufweisen, wobei die Anschlußflächen innerhalb eines Satzes 27 bis 29 gleich groß sind. Bei dem in Fig. 4 beispielhaft dargestellten Testsubstrat 26 sind Kontaktabstände 45, 46, 47, 48 zwischen den durch die Anschlußflächenanordnungen einander zugeordneten Anschlußflächen 42, 43, 44 gleichmäßig gestaffelt, derart, daß bei jedem Anschlußflächenanordnungssatz 27, 28, 29 die Kontaktabstände ausgehend von dem engen Kontaktabstand 45 fortschreitend über die Kontaktabstände 46 und 47 bis zu einem Kontaktabstand 48 um das gleiche Maß größer werden. Dabei sind die jeweiligen Kontaktabstände 45 bis 48 bei den einzelnen Anschlußflächenanordnungssätzen 27 bis 29 gleich groß.

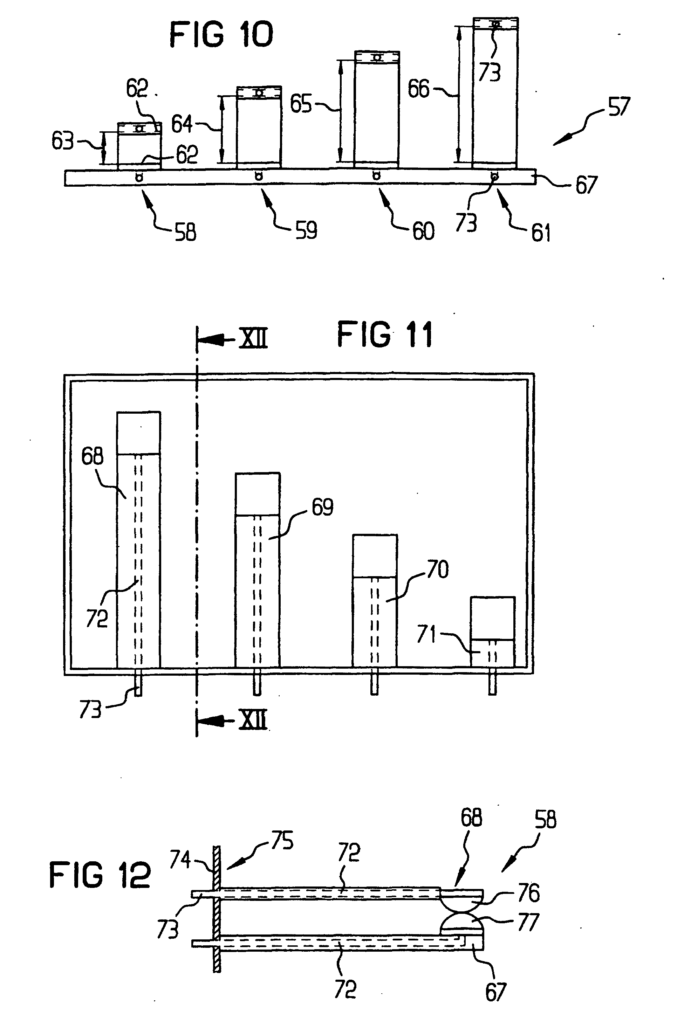

In den **Fig. 5** bis **8** sind zur Erläuterung des unterschiedlichen Abscheidungsverhaltens bzw. dessen Auswirkung auf die Morphologie von Kontaktmetallisierungen 49 bis 52 die Anschlußflächenanordnungen 30 bis 33 des ersten Anschlußflächenanordnungssatzes 27 aus einer Teilschnittdarstellung des Substrats 26 im Bereich der jeweiligen Anschlußflächenanordnung 30 bis 33 dargestellt. Die Darstellungen in den **Fig. 5** bis **8** gelten jeweils für Abscheidungsvorgänge in unterschiedlichen Metallisierungsbädern. Die **Fig. 5** bis **8** geben jeweils die Morphologie der Kontaktmetallisierungen 49 bis 52 in der Verfahrensphase wieder, in der sich ein elektrisch leitfähiger Kontakt zwischen den Anschlußflächen 42 infolge der durch Abscheidung auf den Anschlußflächen entstandenen, über den jeweiligen Kontaktabstand 45, 46, 47 bzw. 48 zusammengewachsenen Kontaktmetallisierungen 49 bis 52 ausbildet. Dabei weisen die jeweils verwendeten Metallisierungsbäder bei ansonsten gleicher Badzusammensetzung eine unterschiedliche Konzentration einer Stabilisierungskomponente auf, die die Zersetzung des Metallisierungsbades verhindern soll. Im vorliegenden Fall nimmt die Stabilisatorkonzentration ausgehend von der Darstellung gemäß **Fig. 5** zur Darstellung gemäß **Fig. 8** hin ab.

Zur grundsätzlichen Erläuterung der Wirkung der Stabilisatorkonzentration eines Metallisierungsbades auf die Morphologie einer Kontaktmetallisierung 53 bzw. 54 wird auf die **Fig. 9** verwiesen, wo die Auswirkungen bei Gegenüberstellung extrem unterschiedlich großer Anschlußflächen 55, 56 noch deutlicher werden. Aufgrund der Endlichkeit der Anschlußflächen 55 und 56 ergibt sich ein differenziertes Diffusionsverhalten bei der Diffusion der Stabilisatorkomponente in die Oberfläche der Anschlußflächen 55 und 56. Im Bereich der Oberfläche der Anschlußflächen 55, 56 kommt es in ausreichend weitem Abstand von den Rändern der Anschlußflächen 55, 56 zu einem im wesentlichen linearen Diffusionsverhalten und im Bereich der Ränder selbst zu einem nicht-linearen Diffusionsverhalten infolge eines Randeffektes. Dieses nicht-lineare Diffusionsverhalten verursacht im Bereich der Ränder eine Verstärkung der durch eine Stabilisatorkomponente, wie beispielsweise Blei, bewirkten Inhibitionswirkung, die einer Abscheidung des Kontaktmaterials aus dem Metallisierungsbad auf die Anschlußflächen 55, 56 entgegenwirkt. Daher stellt sich in einem Abstand von den Rändern der Anschlußflächen 55, 56 eine wesentlich stärkere Abscheidung von Kontaktmaterial auf den Anschlußflächen 55, 56 ein als im Bereich der Ränder selbst. Diese uneinheitliche Abscheidung wird auch als anisotrope Abscheidung bezeichnet. Im Vergleich dazu kommt es in einem von Stabilisierungskomponenten freien Metallisierungsbad, wie beispielsweise in den **Fig. 1** bis **3** dargestellt, zu einer gleichmäßigen, isotropen Abscheidung des Metallisierungsmaterials auf den Anschlußflächen, d. h. im Bereich der Ränder erfolgt die Abscheidung in gleichem Maße wie in einem Bereich der Anschlußflächen mit Abstand von den Rändern.

**Fig. 9** zeigt nun ein insbesondere bei Metallisierungsbädern mit hoher Stabilisatorkonzentration zu beobachtendes Phänomen, das fachsprachlich auch als "Bevelling" bezeichnet wird. Hierbei sind im Bereich der Ränder der Anschlußflächen 55 und 56 starke Abschrägungen der Kontaktmetallisierungen 53, 54 oder auch bei entsprechend hoher Stabilisatorkonzentration eine Unterdrückung der Kontaktmetallisierungen 53, 54 zu erkennen, die praktisch ein Aufwachsen des Kontaktmaterials über die Ränder der Anschlußflächen 55, 56 hinaus verhindern. Dieses "Bevelling" wirkt sich in Abhängigkeit von der Größe der Anschlußfläche auch auf die durch einen Abscheidungsvorgang erzielbare Höhe einer Kontaktmetallisierung 53, 54 entscheidend aus. Wie **Fig. 9** nämlich deutlich zeigt, ist ausgehend von einer identischen Stabilisatorkonzentration bei einer vergleichsweise kleinen Anschlußfläche 55 auch mit einer im Vergleich zu einer größeren Anschlußfläche 56 geringeren Höhe der Kontaktmetallisierung 53 gegenüber der auf der größeren Anschlußfläche 56 abgeschiedenen Kontaktmetallisierung 54 zu rechnen. Bei einer ausreichend hohen Stabilisatorkonzentration kann bei einer kleinen Anschlußfläche die Abscheidung auch vollständig unterbleiben.

Die vorstehenden, unter Bezugnahme auf die **Fig. 5** bis **9** gemachten Ausführungen machen deutlich, daß sich die durch die Stabilisatorkonzentration beeinflußten Abscheidungsvorgänge im Zusammenhang mit einer hinsichtlich ihrer Grundprinzipien in den **Fig. 1** bis **3** dargestellten Vorrichtung auch zur Bestimmung einer nicht bekannten Stabilisatorkonzentration eines Metallisierungsbades nutzen lassen. Hierzu kann das in **Fig. 4** dargestellte Testsubstrat 26 verwendet werden, und zwar so, daß das Testsubstrat 26 für eine vorgegebene Zeitspanne von beispielsweise 10 bis 20 Minuten in ein Metallisierungsbad mit nicht bekannter Stabilisatorkonzentration eingebracht wird. Dabei sind die einzelnen Anschlußflächenanordnungen 27 bis 41 mit ihren jeweiligen Anschlußflächen 42, 43 bzw. 44 in der in den **Fig. 1** bis **3** dargestellten Weise mit einem elektrischen Meßkreis 19 verbunden, der periodisch geschlossen und geöffnet wird. Je nachdem, bei welchen Anschlußflächenanordnungen sich nun innerhalb der vorgegebenen Zeitspanne elektrische Kontakte zwischen den auf den jeweiligen Anschlußflächen durch Abscheidung aufgewachsenen Kontaktmetallisierungen ergeben, lassen sich in einem ersten Ansatz qualitative Rückschlüsse über die im Metallisierungsbad vorhandene Stabilisatorkonzentration geben. Ein Abscheidungsvorgang tritt bei einer Anschlußfläche unterhalb einer bestimmten Mindestgröße und ausreichend hoher Stabilisatorkonzentration nicht auf. Wird am Ende der vorgegebenen Zeitspanne über die abgeschiedenen Kontaktmetallisierungen lediglich ein elektrischer Kontakt bei den Anschlußflächenanordnungen 30 und 31 detektiert, so liegt eine vergleichsweise hohe Stabilisatorkonzentration mit einer entsprechend geringen Abscheiderate vor. Wird hingegen ein elektrischer Kontakt darüber hinaus bei den in vergleichsweise großem Kontaktabstand 47, 48 voneinander angeordneten Anschlußflächen 42 der Anschlußflächenanordnung 32 und 33 detektiert, so liegt eine vergleichsweise geringe Stabilisatorkonzentration mit entsprechend hoher Abscheiderate vor. Eine über diese qualitative Bewertung hinausgehende quantitative Feststellung der Stabilisatorkonzentration wird anschließend durch einen Vergleich mit Referenzmessungen möglich, bei denen bei bekannter Stabilisatorkonzentration eines Metallisierungsbades eine jeweilige Zuordnung zwischen der Stabilisatorkonzentration und einer bestimmten Anschlußflächenanordnung mit definiertem Kontaktabstand erfolgt ist.

Da, wie insbesondere unter Bezugnahme auf **Fig. 9** ausgeführt wurde, die Auswirkung der Stabilisatorkonzentration eines Metallisierungsbades auf die Morphologie einer Kontaktmetallisierung bei unterschiedlich großen Anschlußflächen unterschiedlich ist, kann, wie in **Fig. 4** dargestellt, das Testsubstrat 26 mit unterschiedlich große Anschlußflächen 43 und 44 aufweisenden weiteren Anschlußflächenanordnungssätzen 28 und 29 versehen sein, so daß das Testsubstrat 26 möglichst universell, zumindest jedoch für unterschiedlich große Anschlußflächen Aussagen über die Auswirkungen der Stabilisatorkonzentration auf die Morphologie der Kontaktmetallisierungen ermöglicht.

**Fig. 10** zeigt ein Testsubstrat 57 mit Anschlußflächenanordnungen 58, 59, 60, 61, die jeweils zwei einander zugeordnete Anschlußflächen 62 aufweisen, die bei den einzelnen Anschlußflächenanordnungen 58 bis 61 einen unterschiedlichen Kontaktabstand 63, 64, 65, 66 und gegebenenfalls unterschiedlich große Anschlußflächen aufweisen.

Wie aus einer Zusammenschau der **Fig. 10** und **11** hervorgeht, befinden sich die oberhalb einer Trägerplatte 67 des Substrats 57 angeordneten Anschlußflächen 62 der Anschlußflächenanordnungen 58 bis 61 am freien Ende von tragarmartigen Auslegern 68 bis 71 und liegen im jeweiligen Kontaktabstand 63 bis 66 den zugeordneten Anschlußflächen 62 in der Trägerplatte 67 gegenüber. Sowohl in der Trägerplatte 67 als auch in den Auslegern 68 bis 71 sind Kontaktleitungen 72 vorgesehen, die in Außenkontakte 73 münden, welche eine Kontaktierung der Anschlußflächen 62 durch eine Behälterwand 74 eines Badbehälters 75, wie in **Fig. 12** dargestellt, ermöglichen.

Die Darstellung gemäß **Fig. 12** macht deutlich, daß mit dem Testsubstrat 57 die Ausbildung eines elektrischen Kontakts zwischen zwei sich auf den Anschlußflächen 62 der Anschlußflächenanordnung 58 ausbildenden Kontaktmetallisierungen 76 und 77 nicht parallel zur Oberfläche des Substrats 57, wie es bei dem in **Fig. 4** dargestellten Testsubstrat 26 der Fall ist, sondern vielmehr senkrecht zur Oberfläche des Testsubstrats 57 möglich ist. Damit kann das vorstehend beschriebene Verfahren zur Bestimmung der Stabilisatorkonzentration in einem Metallisierungsbad unter Ausnutzung des sich zwischen den Kontaktmetallisierungen ausbildenden Kurzschlusses auch in solchen Fällen eingesetzt werden, wenn, wie beispielsweise in **Fig. 9** dargestellt, kein Wachstum der Kontaktmetallisierungen infolge des Abscheidungsvorgangs über die Ränder der Anschlußflächen hinaus, sondern lediglich auf der Oberfläche der Anschlußflächen erfolgt. Wie aus einer Zusammenschau der **Fig. 11** und **12** deutlich wird, ermöglicht die Anordnung jeweils einer Anschlußfläche 62 der Anschlußflächenanordnungen 58 bis 61 am Ende der Ausleger 68 bis 71 eine möglichst geringfügige Abdeckung der Trägerplatte 67 durch die Anordnung der oberhalb der Trägerplatte 67 angeordneten Anschlußflächen 62, um eine nach wie vor gute Zugänglichkeit der unteren, in der Trägerplatte 67 angeordneten Anschlußfläche 62 für das im Trägerbad gelöste Metallisierungsmaterial zu gewährleisten und damit den Abscheidevorgang auf den unteren Anschlußflächen möglichst wenig zu beeinträchtigen.

Mit gestricheltem Linienverlauf ist in **Fig. 1** eine mögliche Ergänzung der zur Durchführung des Verfahrens einsetzbaren Vorrichtung dargestellt. Hierbei ist zu den Anschlußflächen 13 und 14 eine Gegenelektrode 76 vorgesehen, die es ermöglicht, daß den Anschlußflächen 13 und 14 ein definiertes Potential U aufgeprägt werden kann. Hierdurch wird eine Beeinflussung der elektrochemischen Vorgänge an den Anschlußflächen möglich und somit eine Anpassung der Vorrichtung an unterschiedliche, insbesondere auch galvanische Metallisierungsmedien. Im dargestellten Ausführungsbeispiel ist die Gegenelektrode nur während der Meßvorgänge von den Anschlüssen getrennt. Darüber hinaus ermöglicht es die Gegenelektrode, die auf den Anschlußflächen abgeschiedene Metallisierung durch anodische Polarisation wieder abzulösen und die Anschlußflächen so für einen weiteren Meßzyklus zu präparieren. Die Gegenelektrode kann hierzu nur zur Regeneration der Anschlußflächen nach einer Messung aktiviert werden.

## Patentansprüche

1. Verfahren zur Ermittlung der Konzentration eines einem Metallisierungsbad hinzugefügten Badstabilisators und/oder einer Abscheidegeschwindigkeit eines Metallisierungsmaterials einer Kontaktmetallisierung im Metallisierungsbad bei Ausbildung der Kontaktmetallisierung für die reproduzierbare Herstellung erhöhter Kontaktmetallisierungen auf Anschlussflächen eines Substrats mittels Abscheidung des Metallisierungsmaterials im Metallisierungsbad,
**dadurch gekennzeichnet,**
**dass** ein Testsubstrat (11, 26, 57) mit mindestens zwei in definiertem Abstand (45 bis 48; 63 bis 66) benachbarten Anschlussflächen (13, 14; 42 bis 44; 62) in das Metallisierungsbad (10) eingebracht wird und die Konzentration des Badstabilisators und/oder die Abscheidegeschwindigkeit aus der Veränderung einer elektrischen Größe infolge eines sich aus der Abscheidung des Metallisierungsmaterials zum Aufbau der Kontaktmetallisierungen (24, 25; 49 bis 54) auf den benachbarten Anschlussflächen ergebenden elektrischen Kontakts ermittelt wird.

2. Verfahren nach Anspruch 1,
**dadurch gekennzeichnet,**
**dass** die Konzentration des dem Metallisierungsbad hinzugefügten Badstabilisators und/oder die Abscheidegeschwindigkeit aus der Veränderung des elektrischen Widerstands eines die Anschlussflächen (13, 14; 42 bis 44; 55, 56; 62) umfassenden elektrischen Messkreises (19) ermittelt wird.

3. Verfahren zur Ermittlung der Konzentration eines einem Metallisierungsbad hinzugefügten Badstabilisators und/oder einer Abscheidegeschwindigkeit eines Metallisierungsmaterials einer Kontaktmetallisierung im Metallisierungsbad bei Ausbildung der Kontaktmetallisierung für die reproduzierbare Herstellung erhöhter Kontaktmetallisierungen auf Anschlussflächen eines Substrats mittels Abscheidung des Metallisierungsmaterials im Metallisierungsbad,
**dadurch gekennzeichnet,**
**dass** ein Testsubstrat mit mindestens einer Anschlussfläche in das Metallisierungsbad eingebracht wird und die Kenngröße aus der Messung einer durch die Masse der Kontaktmetallisierung auf der Anschlussfläche bedingten elektrischen Größe ermittelt wird.

4. Verfahren nach Anspruch 3,
**dadurch gekennzeichnet,**
**dass** die Konzentration des dem Metallisierungsbad hinzugefügten Badstabilisators und/oder die Abscheidegeschwindigkeit aus dem Wert des elektrischen Widerstands eines an die Anschlussfläche angeschlossenen elektrischen Messkreises ermittelt wird/werden.

5. Verfahren nach einem oder mehreren der vorangehenden Ansprüche,
**dadurch gekennzeichnet,**
**dass** zur Erfassung des elektrischen Widerstands der Messkreis (19) nur zeitweise, vorzugsweise periodisch, über eine Widerstandsmesseinrichtung (22) geschlossen wird.

6. Verfahren nach einem oder mehreren der Ansprüche 1 bis 5,
**dadurch gekennzeichnet,**
**dass** zur Ermittlung der Stabilisatorkonzentration das Testsubstrat (11, 26, 57) mit einer Mehrzahl von Anschlussflächenanordnungen (30 bis 41; 58 bis 61) versehen ist, die jeweils zwei einander mit definiertem Kontaktabstand (45 bis 48; 63 bis 66) zugeordnete Anschlussflächen (42 bis 44, 55, 56; 62) umfassen, wobei die Kontaktabstände bei den einzelnen Anschlussflächenanordnungen variieren und/oder unterschiedlich große Anschlussflächen aufweisen, dass das Testsubstrat über eine vorbestimmte Zeitspanne in das Metallisierungsbad (10) eingetaucht wird, während dieser Zeitspanne eine wiederholte Messung des elektrischen Widerstands zwischen den Anschlussflächen der jeweiligen Anschlussflächenanordnungen erfolgt, und die Stabilisatorkonzentration in Abhängigkeit vom maximalen Kontaktabstand der Anschlussflächen mit Kurzschlusskontakt durch Vergleich mit Kontaktabstand-Referenzwerten für bekannte Stabilisatorkonzentrationen ermittelt wird.

7. Verfahren nach einem oder mehreren der Ansprüche 1 bis 5,
**dadurch gekennzeichnet,**
**dass** zur Ermittlung der Abscheidegeschwindigkeit das Testsubstrat, das mit mindestens einer Anschlussflächenanordnung versehen ist, die zwei einander mit definiertem Kontaktabstand zugeordnete Anschlussflächen umfasst, in das Metallisierungsbad eingetaucht wird, anschließend eine wiederholte Messung des elektrischen Widerstands zwischen den Anschlussflächen der Anschlussflächenanordnung erfolgt und die Zeit bis zur Ausbildung eines Kurzschlusskontakts zwischen den Anschlussflächen gemessen wird.

8. Vorrichtung zur Durchführung des Verfahrens nach einem oder mehreren der vorangehenden Ansprüche, mit einem Testsubstrat (11, 26, 57) mit einer Mehrzahl von Anschlussflächenanordnungssätzen (27 bis 29) mit einer Mehrzahl von Anschlussflächenanordnungen (30 bis 41; 58 bis 61)), wobei die Anschlussflächenanordnungen jeweils zwei in definiertem Kontaktabstand (45 bis 48) einander zugeordnete Anschlussflächen (13, 14; 42 bis 44; 55, 56; 62) aufweisen, wobei die Anschlussflächen Kurzschlusspole eines eine Widerstandsmesseinrichtung (22) umfassenden elektrischen Messkreises (19) bilden,
**dadurch gekennzeichnet,**
**dass** die Kontaktabstände (45 bis 48) zwischen einander zugeordneten Anschlussflächen verschiedener Anschlussflächenanordnungen desselben Anschlussflächenanordnungssatzes unterschiedlich sind, wobei jeder Anschlussflächenanordnungssatz Anschlussflächen (42, 43, 44) übereinstimmender Größe aufweist und verschiedene Anschlussflächenanordnungssätze (27 bis 29) Anschlussflächen unterschiedlicher Größe aufweisen.

9. Vorrichtung nach Anspruch 8,
**gekennzeichnet durch**
eine räumliche Anordnung der Anschlussflächen (62), derart, dass zur Ausbildung des Kontaktabstands (63 bis 66) zwischen zwei einander zugeordneten Anschlussflächen (62) die Anschlussflächen in beabstandeten Substratebenen angeordnet sind.

## Claims

1. Method for determining the concentration of a bath stabilizer added to a metallization bath and/or a deposition rate of a metallization material of a contact metallization in the metallization bath with the formation of the contact metallization for the reproducible production of raised contact metallizations on terminal areas of a substrate by means of depositing the metallization material in the metallization bath, **characterized in that** a test substrate (11, 26, 57) having at least two terminal areas (13, 14; 42 to 44; 62) adjacent at a defined spacing (45 to 48; 63 to 66) is introduced into the metallization bath (10) and the concentration of the bath stabilizer and/or the deposition rate are/is determined from the variation in an electrical quantity as a consequence of an electrical contact resulting from the deposition of the metallization material for building up the contact metallizations (24, 25; 49 to 54) on the adjacent terminal areas.

2. Method according to Claim 1, **characterized in that** the concentration of the bath stabilizer added to the metallization bath and/or the deposition rate are/is determined from the variation in the electrical resistance of an electrical measuring circuit (19) encompassing the terminal areas (13, 14; 42 to 44; 55, 56; 62).

3. Method for determining the concentration of a bath stabilizer added to a metallization bath and/or a deposition rate of a metallization material of a contact metallization in the metallization bath with the formation of the contact metallization for the reproducible production of raised contact metallizations on terminal areas of a substrate by means of depositing the metallization material in the metallization bath, **characterized in that** a test substrate having at least one terminal area is introduced into the metallization bath and the parameter is determined from the measurement of an electrical quantity due to the mass of the contact metallization on the terminal area.

4. Method according to Claim 3, **characterized in that** the concentration of the bath stabilizer added to the metallization bath and/or the deposition rate are/is determined from the value of the electrical resistance of an electrical measuring circuit connected to the terminal area.

5. Method according to one or more of the preceding claims, **characterized in that**, to determine the electrical resistance, the measuring circuit (19) is closed only intermittently, preferably periodically, via a resistance-measuring device (22).

6. Method according to one or more of claims 1 to 5, **characterized in that**, to determine the stabilizer concentration, the test substrate (11, 26, 57) is provided with a plurality of terminal area arrangements (30 to 41; 58 to 61) that each comprise two terminal areas (42 to 44, 55, 56; 62) assigned to one another at a defined contact spacing (45 to 48; 63 to 66), the contact spacings varying for the individual terminal area arrangements and/or having terminal areas of different size, and **in that** the test substrate is immersed for a predetermined time interval in the metallization bath (10), during which time interval the electrical resistance between the terminal areas of the respective terminal area arrangements is repeatedly measured and the stabilizer concentration is determined as a function of the maximum contact spacing of the terminal areas with short-circuit contact by comparison with contact spacing reference values for known stabilizer concentrations.

7. Device according to one or more of Claims 1 to 5, **characterized in that**, to determine the deposition rate, the test substrate, which is provided with at least one terminal area arrangement that comprises two terminal areas assigned to one another at a defined contact spacing, is immersed in the metallization bath, then a repeated measurement of the electrical resistance between the terminal areas of the terminal area arrangement is carried out and the time up to the formation of a short-circuit contact between the terminal areas is measured.

8. Device for performing the method according to one or more of the preceding claims, using a test substrate (11, 26, 57) having a plurality of terminal area arrangement sets (27 to 29) comprising a plurality of terminal area arrangements (30 to 41, 58 to 61), the terminal area arrangements each having two terminal areas (13, 14; 42 to 44; 55, 56; 62) assigned to one another at defined contact spacings (45 to 48), the terminal areas forming short-circuit poles of an electrical measuring circuit (19) comprising a resistance measuring device (22), **characterized in that** the contact spacings (45 to 48) between terminal areas, assigned to one another of different terminal area arrangements of the same terminal area arrangement set are different, each terminal area arrangement set having terminal areas (42, 43, 44) of corresponding size and different terminal area arrangement sets (27 to 29) having terminal areas of different size.

9. Device according to Claim 8, **characterized by** a spatial arrangement of the terminal areas (62) such that, to form the contact spacing (63 to 66) between two terminal areas (62) assigned to one another, the terminal areas are disposed in substrate planes that are spaced apart.

## Revendications

1. Procédé pour déterminer la concentration d'un stabilisateur de bain rajouté à un bain de métallisation et/ou une vitesse de séparation d'une matière de métallisation d'une métallisation par contact dans le bain de métallisation lors de la formation de la métallisation par contact, pour la fabrication reproductible de métallisations par contact élevées sur des surfaces de raccordement d'un substrat, par séparation de la matière de métallisation dans le bain de métallisation, **caractérisé en ce qu'**un substrat d'essai (11, 26, 57) avec au moins deux surfaces de raccordement(13, 14 ; 42 à 44 ; 62) voisines à une distance définie (45 à 48 ; 63 à 66) est introduit dans le bain de métallisation (10) et la concentration du stabilisateur de bain et /ou la vitesse de séparation est/sont déterminée(s) à partir de la modification d'une dimension électrique suite à un contact électrique résultant de la séparation de la matière de métallisation pour la création des métallisations par contact (24, 25 ; 49 à 54) sur les surfaces de raccordement voisines.

2. Procédé selon la revendication 1, **caractérisé en ce que** la concentration du stabilisateur de bain rajouté au bain de métallisation et/ ou la vitesse de séparation est/sont déterminée(s) à partir de la modification de la résistance électrique d'un circuit de mesure électrique (19) comprenant les surfaces de raccordement (13, 14 ; 42 à 44 ; 55, 56 ; 62).

3. Procédé pour la détermination de la concentration d'un stabilisateur de bain rajouté à un bain de métallisation et/ou d'une vitesse de séparation d'une matière de métallisation d'une métallisation par contact dans le bain de métallisation, lors de la formation de la métallisation par contact pour la fabrication reproductible de métallisations par contact élevées sur des surfaces de raccordement d'un substrat par séparation de la matière de métallisation dans le bain de métallisation, **caractérisé en ce qu'**un substrat d'essai avec au moins une surface de raccordement est introduit dans le bain de métallisation et la valeur caractéristique issue de la mesure d'une dimension électrique conditionnée par la masse de la métallisation par contact sur la surface de raccordement est déterminée.

4. Procédé selon la revendication 3, **caractérisé en ce que** la concentration du stabilisateur de bain rajouté au bain de métallisation et/ou la vitesse de séparation est/sont déterminé(s) à partir de la valeur de la résistance électrique d'un circuit de mesure électrique raccordé sur la surface de raccordement.

5. Procédé selon l'une quelconque ou plusieurs des revendications précédentes, **caractérisé en ce que** pour la détection de la résistance électrique, le circuit de mesure (19) n'est fermé que temporellement, de préférence périodiquement par l'intermédiaire d'un système de mesure de la résistance (22).

6. Procédé selon l'une quelconque ou plusieurs des revendications 1 à 5, **caractérisé en ce que** pour la détermination de la concentration en stabilisateur, le substrat d'essai (11, 26, 57) est muni d'une pluralité de configurations de surfaces de raccordement (30 à 41 ; 58 à 61), qui comprennent respectivement deux surfaces de raccordement associées (42 à 44 , 55, 56 ; 62) entre elles à une distance de contact définie (45 à 48, 63 à 66), les distances de contact entre les configurations individuelles de surfaces de contact variant et/ou présentant des surfaces de raccordement de différentes dimensions, **en ce que** le substrat d'essai est plongé dans la bain de métallisation (10) pendant une période définie, **en ce que** pendant cette période, une mesure répétée de la résistance électrique entre les surfaces de raccordement des configurations respectives de surfaces de raccordement a lieu et la concentration en stabilisateur est déterminée en fonction de la distance maximale entre les contacts des surfaces de raccordement avec contact de court-circuit, par comparaison avec les valeurs de référence pour les distances de contact pour des concentrations en stabilisateur connues.

7. Procédé selon l'une quelconque ou plusieurs des revendications 1 à 5, **caractérisé en ce que** pour la détermination d'une vitesse de séparation, le substrat d'essai qui est muni d'au moins une configuration de surfaces de raccordement, qui comprend deux surfaces de raccordement associées entre elles avec une distance définie entre les contacts est plongé dans le bain de métallisation et **en ce qu'**ensuite une mesure répétée de la résistance électrique entre les surfaces de raccordement de la configuration de surfaces de raccordement a lieu et le temps jusqu'à la création d'un contact par court-circuit entre les surfaces de raccordement est mesuré.

8. Dispositif pour la réalisation du procédé selon l'une quelconque ou plusieurs des revendications précédentes, avec un substrat d'essai (11, 26, 57) avec une pluralité de jeux de configurations de surfaces de raccordement (27 à 29), avec une pluralité de configurations de surfaces de raccordement (30 à 41 ; 58 à 61), les configurations de surfaces de raccordement étant munies respectivement de deux surfaces de raccordement (13, 14 ; 42 à 44 ; 55, 56 ; 62) associées entre elles à une distance de contact définie (45 à 48), les surfaces de raccordement formant des pôles de court-circuit d'un circuit de mesure électrique (19) comprenant un système de mesure de la résistance (22), **caractérisé en ce que** les distances de contact (45 à 48) entre deux surfaces de raccordement associées de différentes configurations de surfaces de raccordement du même jeu de configurations de surfaces de raccordement sont différentes, chaque jeu de configurations de surfaces de raccordement étant muni de surfaces de raccordement (42, 43, 44) de dimensions concordantes et des jeux de configurations de surfaces de raccordement différents (27 à 29) présentant des surfaces de raccordement de dimensions différentes.

9. Dispositif selon la revendication 8, **caractérisé par** une configuration physique des surfaces de raccordement (62), de façon à ce que pour la création de la distance de contact (63 à 66) entre deux surfaces de raccordement (62) associées entre elles, les surfaces de raccordement soient disposées sur des plans de substrat distancés.
